# EUROPEAN PATENT APPLICATION

(11) **EP 4 412 419 A1**
(43) Date of publication of application: **07.08.2024**
(21) Application number: 21959320.9
(22) Date of filing: 29.09.2021
(51) Int. Cl.: H05K 13/04

(54) **WORK MACHINE FOR BOARD AND BOARD MANUFACTURING METHOD**

(71) Applicant: Fuji Corporation, Chiryu-shi, Aichi 472-8686 (JP)
(72) Inventor: TORII, Hisahiro, Chiryu-shi, Aichi 472-8686 (JP); NAGAISHI, Takuya, Chiryu-shi, Aichi 472-8686 (JP); IKEDA, Mitsutoshi, Chiryu-shi, Aichi 472-8686 (JP); AWADA, Takashi, Chiryu-shi, Aichi 472-8686 (JP)
(74) Representative: Grünecker Patent- und Rechtsanwälte PartG mbB
(86) International application number: PCT/JP2021/035886
(87) International publication number: WO 2023/053274

(57) **Abstract**

A component mounter includes a cutting device that cuts a lead of a taped component in which a radial lead component is taped on a carrier tape to separate the radial lead component from the carrier tape, and a bad lead cut detection sensor that detects that the cutting device has failed to separate the radial lead component from the carrier tape.

## Description

### Technical Field

The present disclosure relates to a technique for supplying a lead component to be mounted on a board.

### Background Art

Patent Literature 1 describes a board work machine in which after a lead wire of a lead component is inserted into a board, the lead wire protruding from the back surface of the board is cut and bent.

### Patent Literature

Patent Literature 1: International Publication No. WO 2021/014635 A1

### Summary of the Invention

### Technical Problem

However, the board work machine described in Patent Literature 1 does not consider the supply of a lead component to the board work machine, and cannot deal with a problem that may occur when, for example, each lead component is separated and supplied from a taped lead component that is taped on a carrier tape.

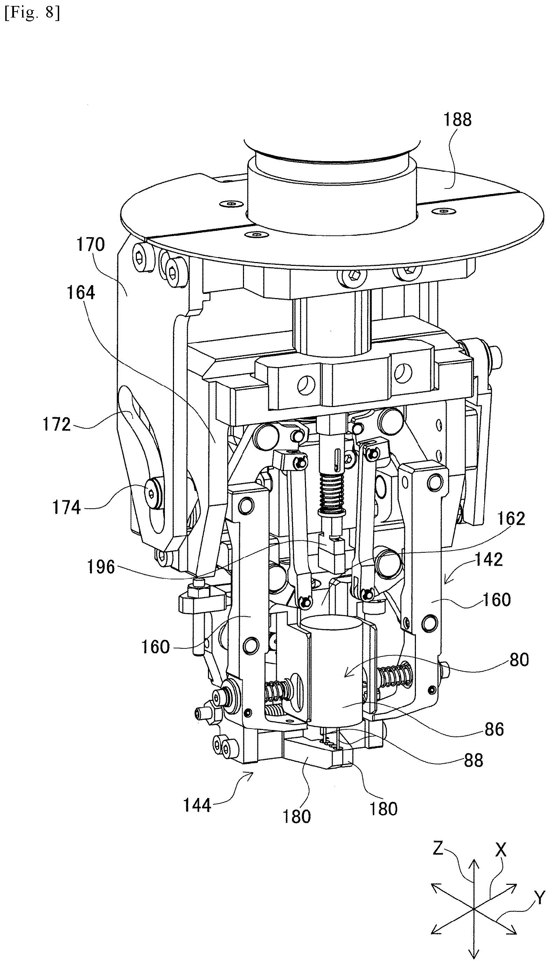

Specifically, in this case, the lead component is separated from the carrier tape by cutting the lead of the taped lead component, but the lead is sometimes not cut properly and the lead component may be supplied with the carrier tape still attached. When the lead component supplied with the carrier tape attached thereto is inserted into a board in this manner, the carrier tape becomes an obstacle to the insertion, and the gripping claws (gripping claws 180 in Fig. 8 described later) used when the lead component is inserted into the board may be damaged.

An object of the present disclosure is to provide a technique capable of detecting that a cutting device has failed to separate a lead component from a carrier tape before the lead component is inserted into a board.

### Solution to Problem

In order to achieve the above object, a board work machine of the present disclosure includes a cutting device configured to cut the lead of a taped lead component that is taped on a carrier tape to separate the lead component from the carrier tape, and a detection device configured to detect that the cutting device has failed to separate the lead component from the carrier tape.

### Advantageous Effect of the Invention

According to the present disclosure, it is possible to detect that a cutting device has failed to separate a lead component from a carrier tape before the lead component is inserted into a board.

### Brief Description of Drawings

Fig. 1 is a perspective view illustrating a component mounter.
Fig. 2 is a perspective view illustrating the component mounter.
Fig. 3 is a perspective view illustrating a cutting device.
Fig. 4 is a perspective view illustrating a component mounting device.
Fig. 5 is a perspective view illustrating the component mounting device.
Fig. 6 is a perspective view illustrating the cutting device and the component mounting device.
Fig. 7 is a cross-sectional view taken along the line B-B of Fig. 6.
Fig. 8 is a perspective view illustrating a second chuck and a third chuck.
Fig. 9 is a perspective view illustrating the component mounting device.
Fig. 10 is a side view illustrating the cutting device and the component mounting device.
Fig. 11 is a side view illustrating a state in which the component mounting device conveys a radial lead component having a good lead cut.
Fig. 12 is a side view illustrating a state in which the component mounting device conveys a radial lead component having a bad lead cut.
Fig. 13 is a side view illustrating a state in which the component mounting device clamps a radial lead component having a bad lead cut.
Fig. 14 is a side view illustrating a state in which the component mounting device conveys a radial lead component having a bad lead cut to a takeout position.
Fig. 15 is a block view illustrating a control device of the component mounter.

### Description of Embodiments

Embodiments of the present disclosure will be described in detail below with reference to the accompanying drawings.

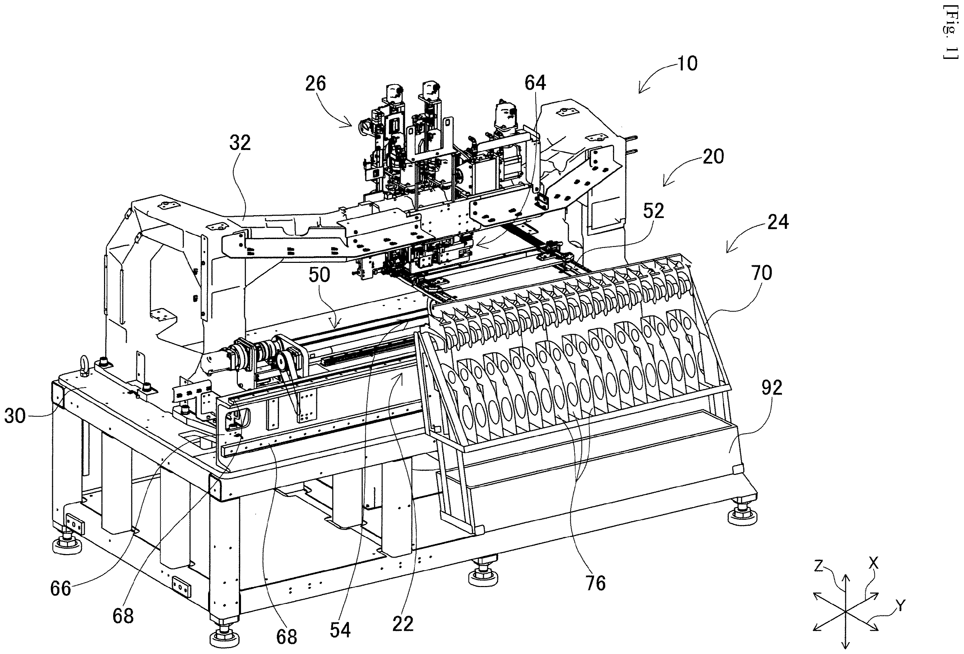

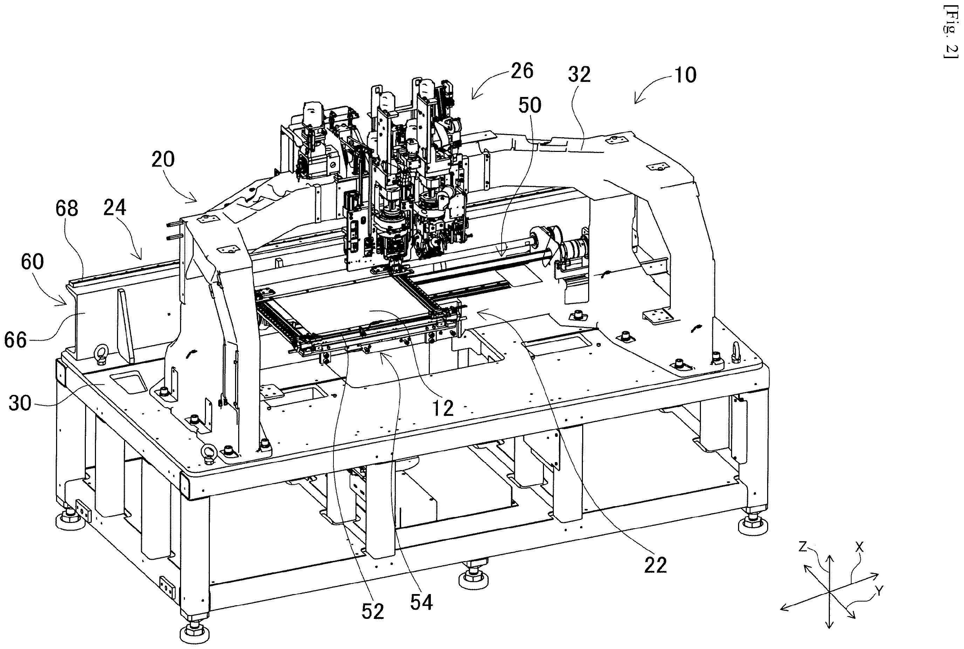

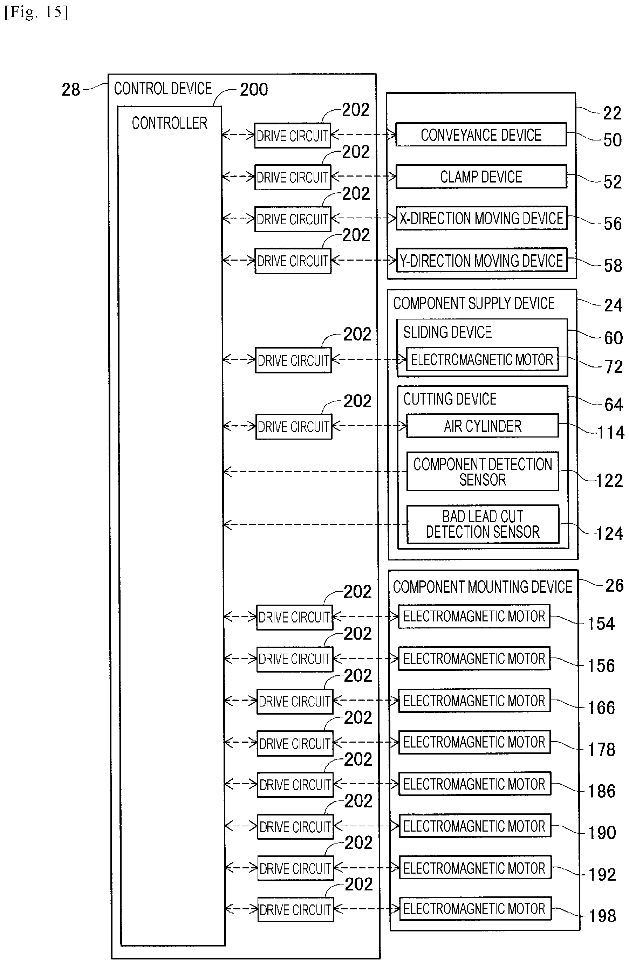

Figs. 1 and 2 illustrate component mounter 10. Component mounter 10 is a device that executes mounting work of a component on circuit base material 12. Component mounter 10 includes device main body 20, board holding device 22, component supply device 24, component mounting device 26, and control device 28 (see Fig. 15). Examples of circuit base material 12 include a circuit board, a base material having a three-dimensional structure, and the like, and examples of the circuit board include a printed wiring board, a printed circuit board, and the like.

Device main body 20 includes frame 30 and beam 32 suspended on frame 30. Board holding device 22 is disposed on the upper surface of frame 30, and includes conveyance device 50, clamp device 52, and moving device 54. Conveyance device 50 is a device that conveys circuit base material 12, and clamp device 52 is a device that holds circuit base material 12. Accordingly, board holding device 22 conveys circuit base material 12 by conveyance device 50, and securely holds the circuit base material 12 conveyed to a predetermined position by clamp device 52. The conveyance direction of circuit base material 12 is referred to as an X direction, a horizontal direction perpendicular to that direction will be referred to as a Y direction, and a vertical direction is referred to as a Z direction. Further, moving device 54 includes X-direction moving device 56 (see Fig. 15) and Y-direction moving device 58 (see Fig. 15). X-direction moving device 56 is a device that moves circuit base material 12 held by clamp device 52 in the X direction, and Y-direction moving device 58 is a device that moves circuit base material 12 held by clamp device 52 in the Y direction. Accordingly, circuit base material 12 held by clamp device 52 is moved to a position on the frame by X-direction moving device 56 and Y-direction moving device 58, and is positioned and stopped.

Component supply device 24 includes sliding device 60, a tape feeder (not illustrated), and cutting device 64. Sliding device 60 includes holding wall 66, sliding rail 68, and feeder holding stand 70, and holding wall 66 is provided upright on the edge of the upper surface of frame 30 in the Y direction so as to extend in the X direction. Sliding rail 68 is fixed to holding wall 66 so as to extend in the X direction, and feeder holding stand 70 is slidably held by sliding rail 68. Feeder holding stand 70 slides to a position in accordance with the operation of electromagnetic motor 72 (see Fig. 15). Accordingly, feeder holding stand 70 slides to a position in the X direction along holding wall 66, and is positioned and stopped. The side on which holding wall 66 of component mounter 10 is disposed is referred to as a front side, and the opposite side is referred to as a rear side. That is, the Y direction is the front-rear direction in component mounter 10, and the X direction is the left-right direction in component mounter 10.

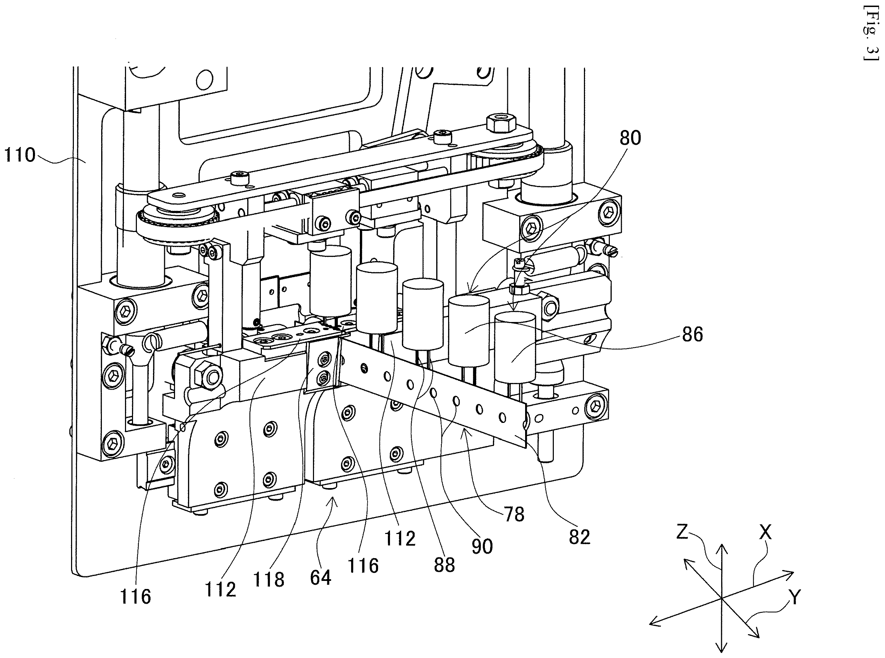

Further, multiple slots 76 are formed side by side in the X direction in feeder holding stand 70, and the tape feeder is detachably positioned and mounted in each of multiple slots 76 by one touch of an operator. The tape feeder is a device that feeds taped component 78 (see Fig. 3) toward cutting device 64. Taped component 78 includes multiple radial lead components 80 and carrier tape 82, as illustrated in Fig. 3. Radial lead component 80 includes substantially cylindrical main body 86 and two leads 88 extending in the same direction from the lower surface of main body 86. Two leads 88 of radial lead component 80 are taped to carrier tape 82 at the lower end portions thereof. Further, multiple feeding holes 90 are formed at a uniform pitch in carrier tape 82. Multiple radial lead components 80 are taped to carrier tape 82 at the same pitch as the formation pitch of feeding holes 90.

As illustrated in Fig. 1, storage container 92 is disposed below feeder holding stand 70 on which the tape feeder is mounted, and taped component 78 is stored in a folded state in storage container 92. One end of taped component 78 is pulled out from storage container 92, and the one end is inserted into the tape feeder.

Further, cutting device 64 is a device that separates radial lead component 80 from taped component 78 by cutting leads 88 taped to taped component 78 fed from the tape feeder, and is attached and fixed to the lower surface side of beam 32 as illustrated in Fig. 1. Specifically, plate-shaped bracket 110 illustrated in Fig. 3 is fixed to the lower surface of beam 32 in a position extending downward. Further, cutting device 64 has a pair of substantially block-shaped sliders 112, and the pair of sliders 112 are held by bracket 110 on the front side of bracket 110 so as to move toward and away from each other in the X direction. The pair of sliders 112 are controllably moved toward and away from each other by the operation of air cylinder 114 (see Fig. 15).

The upper surface of each of the pair of sliders 112 is substantially a horizontal surface, and the front surface of each of the pair of sliders 112 is substantially a vertical surface. A pair of lead cutters 116 are fixed to the upper surfaces of the pair of sliders 112 with the cutting edges facing each other. The pair of lead cutters 116 are fixed to the upper surfaces of the pair of sliders 112 with the cutting edges protruding from the ends of sliders 112 in the X direction. Further, a pair of tape cutters 118 are fixed to the front surfaces of the pair of sliders 112 with the cutting edges facing each other. The pair of tape cutters 118 are fixed to the front surfaces of the pair of sliders 112 with the cutting edges protruding from the ends of sliders 112 in the X direction.

Lead 88 taped on carrier tape 82 extends upward from the gap between the pair of sliders 112 and is inserted between the pair of lead cutters 116 fixed to the upper surfaces of the pair of sliders 112. In a state where a pair of leads 88 of one radial lead component 80 are inserted between the pair of lead cutters 116, the pair of sliders 112 are brought closer to the operation of air cylinder 114, whereby the pair of leads 88 are cut by the pair of lead cutters 116. Thus, one radial lead component 80 is separated from taped component 78 in cutting device 64.

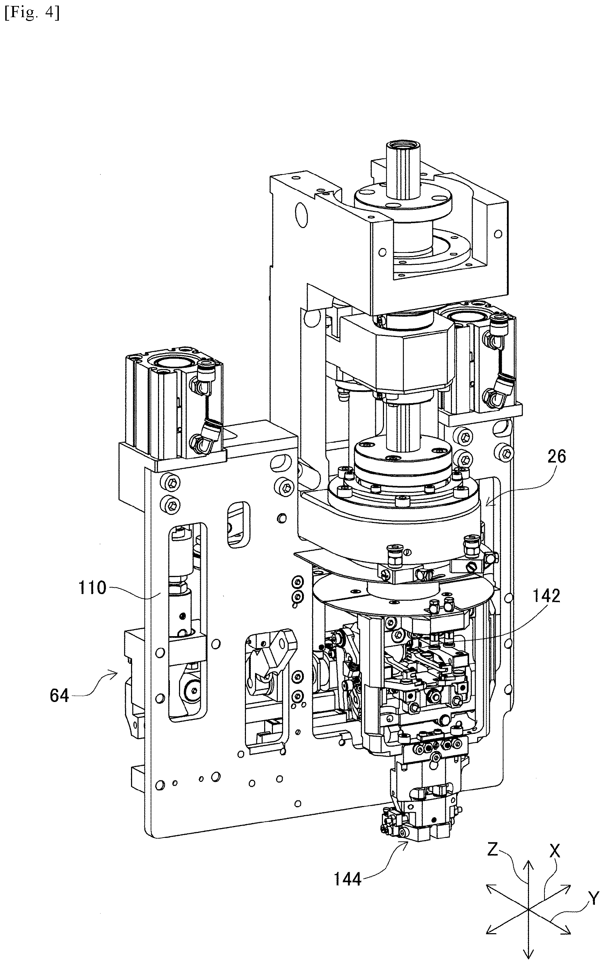

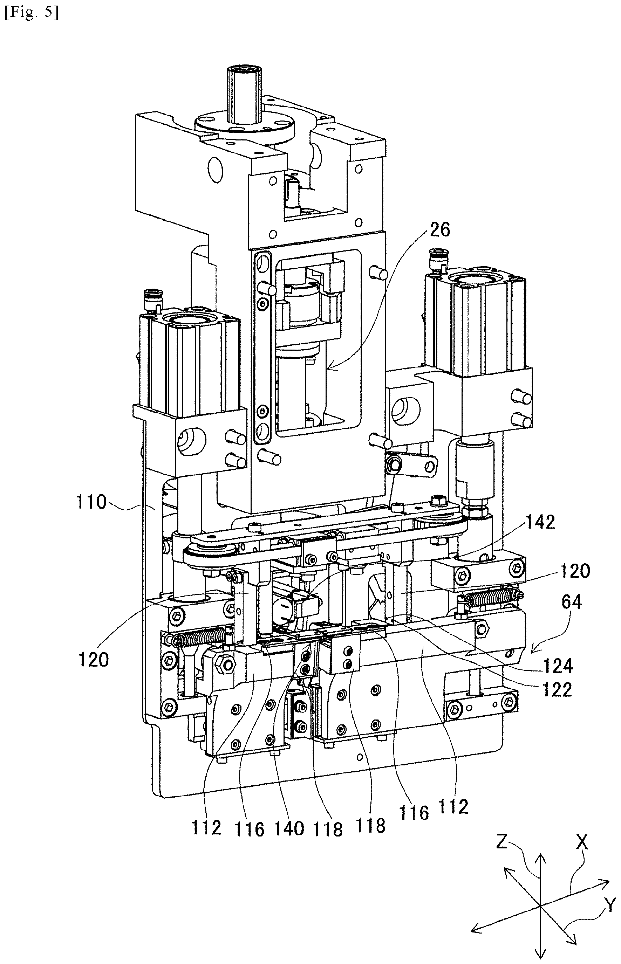

Further, component mounting device 26 is a device for mounting radial lead component 80 separated from taped component 78 by cutting device 64 on circuit base material 12, and is disposed on beam 32 as illustrated in Figs. 1 and 2. Specifically, as illustrated in Figs. 4 and 5, component mounting device 26 is disposed on a surface of bracket 110 on a side opposite to cutting device 64 where cutting device 64 is disposed. That is, cutting device 64 is disposed on the front side surface of bracket 110, and component mounting device 26 is disposed on the rear side surface of bracket 110. Fig. 4 is a view illustrating a rear side surface of bracket 110, and Fig. 5 is a view illustrating a front side surface of bracket 110.

Component mounting device 26 includes three chucks of first chuck 140, second chuck 142, and third chuck 144. First chuck 140 grips radial lead component 80 separated from taped component 78 by cutting device 64, second chuck 142 grips radial lead component 80 transferred from first chuck 140, and third chuck 144 grips radial lead component 80 transferred from second chuck 142 to mount radial lead component 80 on circuit base material 12.

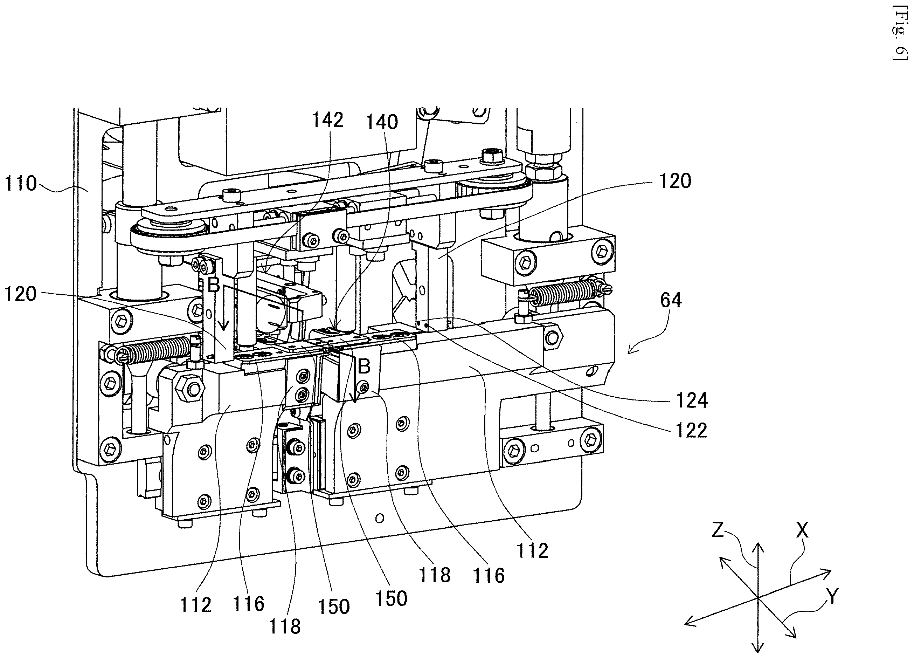

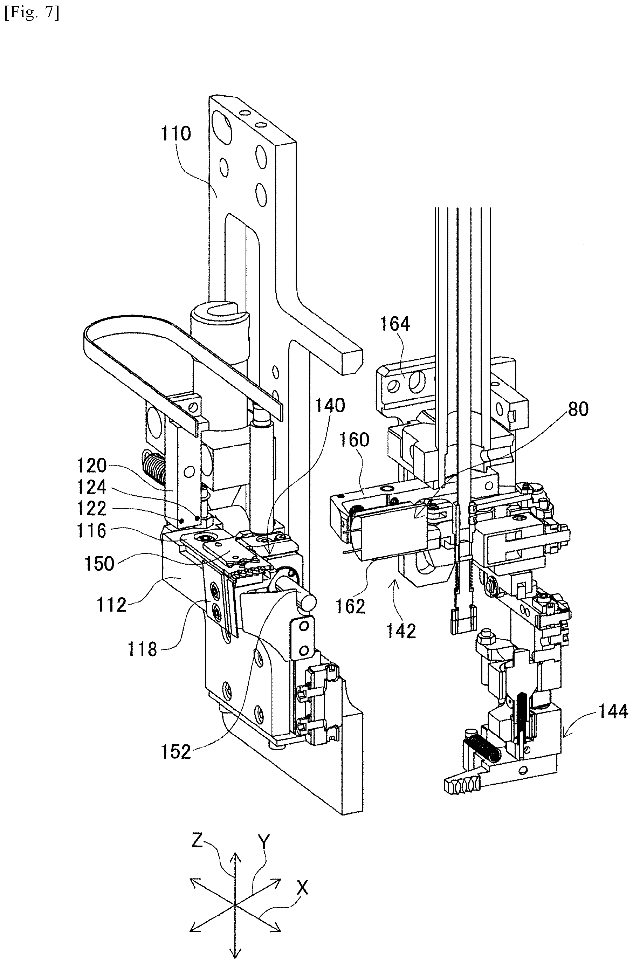

As illustrated in Fig. 6 and Fig. 7 which is a cross-sectional view taken along the line B-B of Fig. 6, first chuck 140 includes a pair of gripping claws 150 and spline shaft 152. Spline shaft 152 is disposed on the rear side of the pair of sliders 112 so as to extend in the X direction, and is held by bracket 110 so as to be rotatable about the axis. The pair of gripping claws 150 are held by spline shaft 152 so as to move toward and away from each other in the X direction, and the respective positions are controllably moved toward and away from each other by the operation of electromagnetic motor 154 (see Fig. 15). Further, spline shaft 152 is controllably rotated by the operation of electromagnetic motor 156 (see Fig. 15), and the pair of gripping claws 150 held by spline shaft 152 rotate 90° in the front-rear direction.

When the pair of gripping claws 150 are rotated forward, gripping claws 150 are positioned above the pair of lead cutters 116 as illustrated in Fig. 6. Therefore, when the pair of gripping claws 150 are rotated forward by the operation of electromagnetic motor 156 and move toward each other by the operation of electromagnetic motor 154, leads 88 of radial lead component 80 separated from taped component 78 can be gripped by the pair of gripping claws 150. When the pair of gripping claws 150 are rotated rearward, the pair of gripping claws 150 are rotated to a position where radial lead component 80 gripped by the pair of gripping claws 150 can be delivered to second chuck 142.

As illustrated in Fig. 6, a pair of sensor brackets 120 are fixed to bracket 110 in a position extending downward. Each of sensor brackets 120 has a quadrangular prism shape, and each of sensor brackets 120 is fixed in a state in which one of four surfaces constituting a peripheral wall thereof faces each other. Component detection sensor 122 and bad lead cut detection sensor 124 are provided on each of the opposing surfaces of each sensor bracket 120. In the present embodiment, transmissive optical sensors are used for both sensors 122 and 124. Accordingly, light emitting parts of both sensors 122 and 124 are provided on one opposing surface of a first one of sensor brackets 120, and light receiving parts of both sensors 122 and 124 are provided on one opposing surface of a second one of sensor brackets 120.

When cutting device 64 performs an operation of separating one radial lead component 80 from taped component 78, component detection sensor 122 detects whether the pair of leads 88 of radial lead component 80 to be separated is inserted between the pair of lead cutters 116. Specifically, control device 28 (see Fig. 15) checks the output from component detection sensor 122 at the timing when one radial lead component 80 is fed out from the tape feeder to cutting device 64, and determines that radial lead component 80 to be separated is at an appropriate cutting position when a decrease in the output is detected. Component detection sensor 122 is installed at a position where the optical axis is blocked by, for example, one lead 88 of the pair of leads 88 of radial lead component 80 when radial lead component 80 to be separated is at an appropriate cutting position. Of course, the installation position of component detection sensor 122 is not limited thereto as long as it is possible to detect that radial lead component 80 to be separated is at an appropriate cutting position.

Bad lead cut detection sensor 124 detects that cutting device 64 has failed to cut the pair of leads 88 of radial lead component 80 to be separated and a part of carrier tape 82 remains attached to leads 88. Specifically, control device 28 (see Fig. 15) checks the output from bad lead cut detection sensor 124 at a predetermined timing while radial lead component 80 after the cutting operation by cutting device 64 is gripped by the pair of gripping claws 150, the pair of gripping claws 150 are rotated rearward, and radial lead component 80 gripped by the pair of gripping claws 150 reaches a position where radial lead component 80 can be delivered to second chuck 142. When a decrease in the output is detected from bad lead cut detection sensor 124, control device 28 determines that a part of carrier tape 82 remains attached to leads 88, that is, cutting device 64 has failed to cut the pair of leads 88 of radial lead component 80 to be separated. The predetermined timing is a timing at which bad lead cut detection sensor 124 can detect a part of carrier tape 82 remaining attached to the pair of leads 88 of radial lead component 80 in the middle of being conveyed by the pair of gripping claws 150, that is, a timing at which the pair of gripping claws 150 are in a predetermined range of rotation. Conversely, bad lead cut detection sensor 124 is installed at a position where a part of carrier tape 82 remaining attached to the pair of leads 88 of radial lead component 80 can be detected when the pair of gripping claws 150 are in the predetermined range of rotation.

As illustrated in Figs. 7 and 8, second chuck 142 includes a pair of gripping claws 160, placement plate 162, and bracket 164. Fig. 8 is a view illustrating second chuck 142 viewed from the front side. The pair of gripping claws 160 are held by bracket 164 so as to move toward and away from each other in the X direction, and the respective positions are controllably moved toward and away by the operation of electromagnetic motor 166 (see Fig. 15). Further, placement plate 162 is fixedly held by bracket 164 between the pair of gripping claws 160. Placement plate 162 is curved in an arc shape according to cylindrical main body 86 of radial lead component 80.

Further, bracket 164 is sandwiched between a pair of support walls 170 (only one of the pair of support walls 170 is illustrated in Fig. 8) on both side surfaces in the X direction. A pair of cam grooves 172 are formed in the pair of support walls 170, and a pair of rollers 174 having an axis in the X direction are disposed on both side surfaces of bracket 164 in the X direction. When the pair of rollers 174 are fitted into the pair of cam grooves 172, bracket 164 is held by the pair of support walls 170. The shape of cam groove 172 is substantially an arc shape, is curved upward toward the rear, and is curved downward toward the front. As illustrated in Fig. 8, bracket 164 is moved down with respect to support wall 170, and roller 174 is moved toward the lower end of cam groove 172, whereby the pair of gripping claws 160 and placement plate 162 are in a position extending in the vertical direction. At this time, the distal ends of the pair of gripping claws 160 face downward. Meanwhile, as illustrated in Fig. 6, bracket 164 is moved up with respect to support wall 170, and roller 174 moves toward the upper end of cam groove 172, whereby the pair of gripping claws 160 and placement plate 162 are in a position extending in the front-rear direction. At this time, the distal ends of the pair of gripping claws 160 face forward. Bracket 164 is controllably moved up and down with respect to support wall 170 by the operation of electromagnetic motor 178 (Fig. 15).

In addition, when bracket 164 is moved up with respect to support wall 170 and the pair of gripping claws 160 and placement plate 162 of second chuck 142 are in a position extending in the front-rear direction, placement plate 162 is positioned behind radial lead component 80 gripped by the pair of gripping claws 150 of first chuck 140. At this time, the pair of gripping claws 160 of second chuck 142 are separated from each other. Therefore, when the pair of gripping claws 150 of first chuck 140 are rotated rearward, main body 86 of radial lead component 80 gripped by the pair of gripping claws 150 is placed on placement plate 162. When main body 86 of radial lead component 80 is placed on placement plate 162, the pair of gripping claws 160 of second chuck 142 move toward each other, whereby main body 86 of radial lead component 80 placed on placement plate 162 is gripped by the pair of gripping claws 160. Further, after main body 86 of radial lead component 80 is placed on placement plate 162, the pair of gripping claws 150 are separated from each other, whereby the gripping of radial lead component 80 by first chuck 140 is released. Thus, radial lead component 80 gripped by first chuck 140 is transferred to second chuck 142 and gripped by second chuck 142.

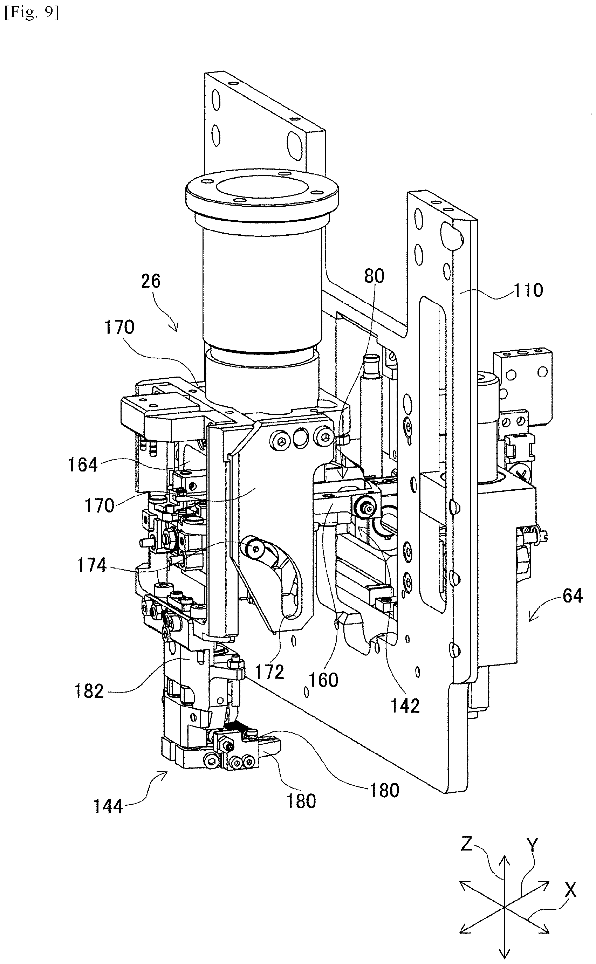

As illustrated in Fig. 9, third chuck 144 is disposed below the pair of support walls 170 and includes a pair of gripping claws 180. Hanging member 182 is fixed to the rear side of the pair of support walls 170, and hanging member 182 extends downward from the lower ends of the pair of support walls 170. The pair of gripping claws 180 are disposed at the lower end of hanging member 182 so as to move toward and away from each other, and the pair of gripping claws 180 extend forward. That is, the pair of gripping claws 180 of third chuck 144 are disposed on the pair of support walls 170 via hanging member 182 and extend downward from the pair of support walls 170. The pair of gripping claws 180 are controllably moved toward and away from each other by the operation of electromagnetic motor 186 (see Fig. 15).

Further, when bracket 164 held by the pair of support walls 170 is moved down with respect to support walls 170, the distal ends of the pair of gripping claws 160 of second chuck 142 held by bracket 164 face downward as described above. At this time, the distal ends of the pair of leads 88 of radial lead component 80 gripped by gripping claws 160 of second chuck 142 also face downward. When bracket 164 moves down, the pair of gripping claws 180 of third chuck 144 are separated from each other. Then, the pair of leads 88 whose distal ends face downward are inserted between the pair of gripping claws 180 of third chuck 144. At this time, as the pair of gripping claws 180 are moved toward each other, the pair of leads 88 of radial lead component 80 are gripped by the pair of gripping claws 180 as illustrated in Fig. 8. Further, after the pair of leads 88 of radial lead component 80 are gripped by the pair of gripping claws 180 of third chuck 144, as the pair of gripping claws 160 of second chuck 142 are separated from each other, the gripping of radial lead component 80 by second chuck 142 is released. Thus, radial lead component 80 gripped by second chuck 142 is transferred to third chuck 144 and gripped by third chuck 144.

As illustrated in Fig. 8, the pair of support walls 170 on which the pair of gripping claws 180 of third chuck 144 are disposed are fixed to flange 188 at the upper end. Flange 188 is controllably moved up and down by the operation of electromagnetic motor 190 (see Fig. 15). Accordingly, the position of radial lead component 80 gripped by the pair of gripping claws 180 of third chuck 144 in the vertical direction can be changed freely. Flange 188 is controllably rotated on the XY plane by the operation of electromagnetic motor 192 (see Fig. 15).

Further, pusher 196 is disposed above radial lead component 80 gripped by third chuck 144. Pusher 196 is held by bracket 164 so as to move up and down, and is controllably moved up and down by the operation of electromagnetic motor 198 (see Fig. 15). As a result, as pusher 196 moves down, radial lead component 80 gripped by third chuck 144 is pushed downward by pusher 196.

Further, as illustrated in Fig. 15, control device 28 includes controller 200 and multiple drive circuits 202. Multiple drive circuits 202 are connected to conveyance device 50, clamp device 52, X-direction moving device 56, Y-direction moving device 58, air cylinder 114, and electromagnetic motors 72, 154, 156, 166, 178, 186, 190, 192, and 198. Controller 200 includes CPU, ROM, RAM, and the like, is mainly a computer, and is connected to multiple drive circuits 202. Controller 200 is also connected to component detection sensor 122 and bad lead cut detection sensor 124. Accordingly, operations of board holding device 22, component supply device 24, and component mounting device 26 are controlled by controller 200.

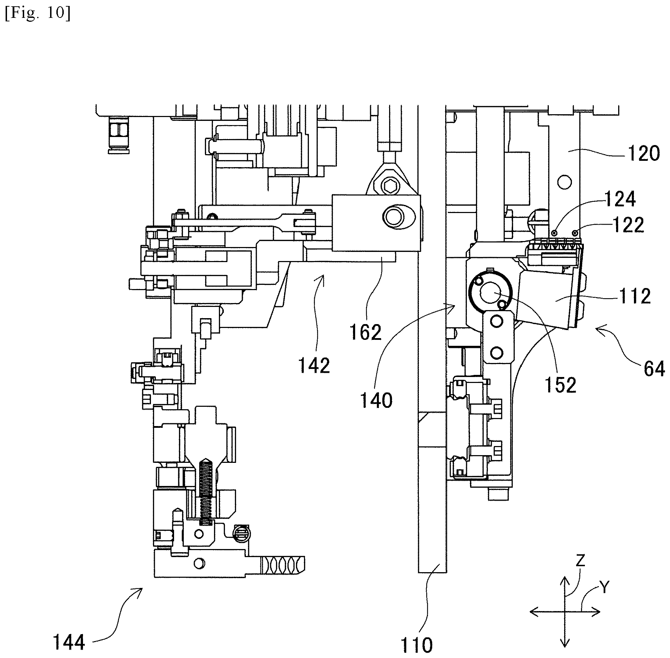

Fig. 10 illustrates a state before taped component 78 is conveyed to cutting device 64. At this time, light is emitted from each light emitting part of component detection sensor 122 and bad lead cut detection sensor 124. That is, component detection sensor 122 and bad lead cut detection sensor 124 are always in the ON state during the operation of component mounter 10 before or after taped component 78 is conveyed to cutting device 64.

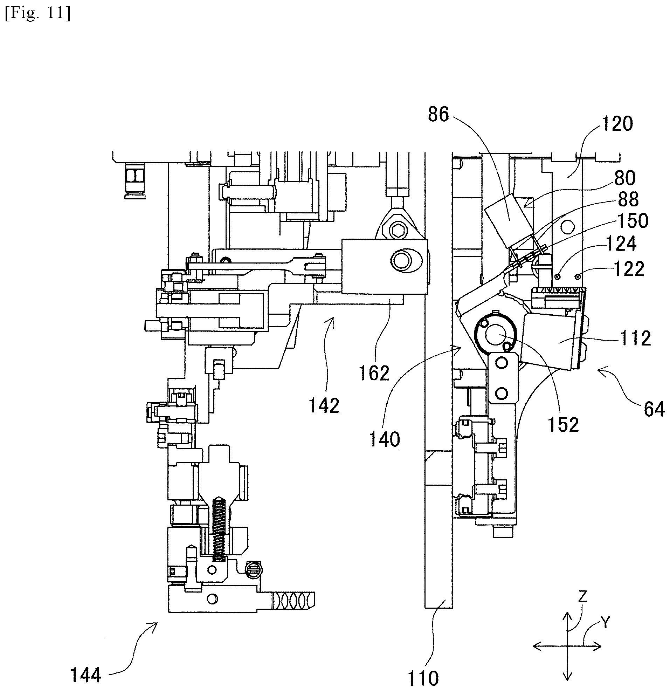

Fig. 11 illustrates a state in which one radial lead component 80 is normally cut from taped component 78, the pair of leads 88 of radial lead component 80 to which part of carrier tape 82 is not attached are being conveyed to the delivery position of second chuck 142 by the pair of gripping claws 150. In this state, the optical axis of bad lead cut detection sensor 124 is not blocked, and a decrease in the output is not detected from bad lead cut detection sensor 124. Accordingly, control device 28 determines that the pair of leads 88 of radial lead component 80 in the middle of being conveyed have been cut more properly by cutting device 64, and performs normal insertion control of radial lead component 80 into circuit base material 12.

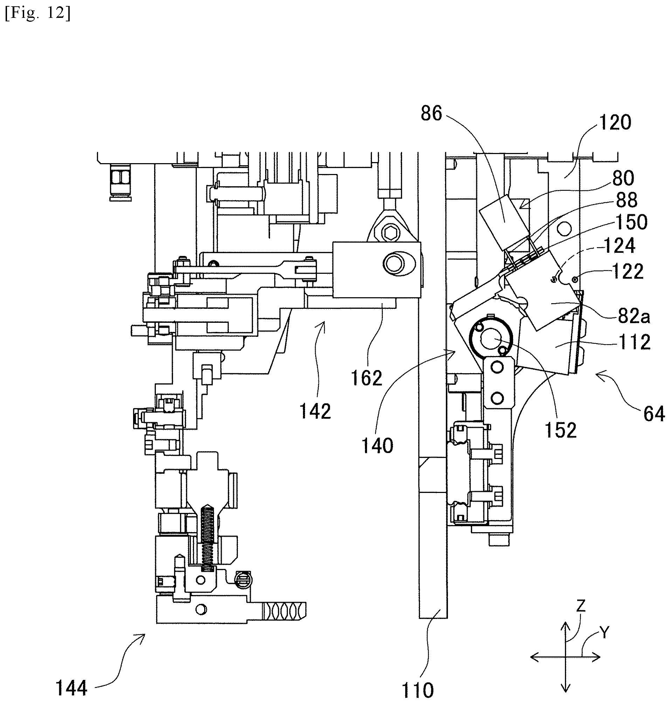

Fig. 12 illustrates a state in which part 82a of carrier tape 82 is attached to the pair of leads 88 of radial lead component 80 although the conveyance timing of radial lead component 80 is the same as that in Fig. 11. In this state, since the optical axis of bad lead cut detection sensor 124 is blocked, a decrease in the output is detected from bad lead cut detection sensor 124. Accordingly, control device 28 determines that the pair of leads 88 of radial lead component 80 in the middle of being conveyed are not cut by cutting device 64 more properly, and stops the operation of component mounter 10. Then, control device 28 executes a component discarding command for radial lead component 80 in the middle of being conveyed.

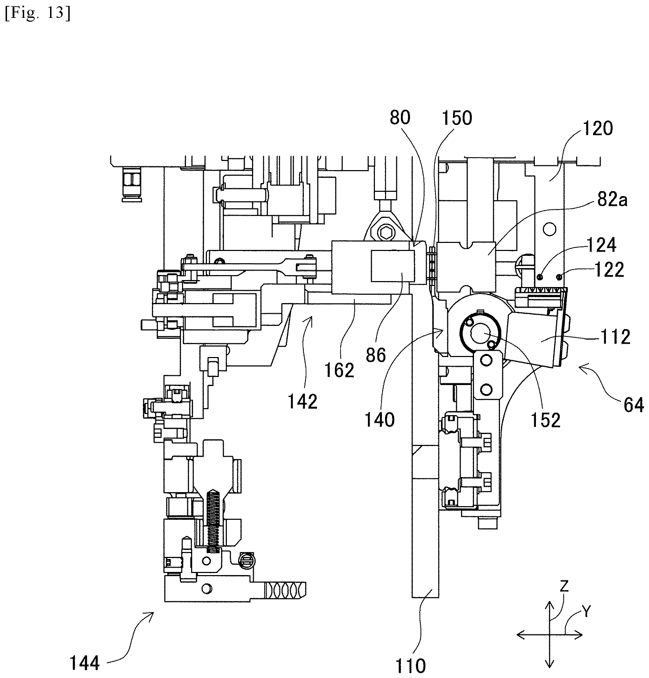

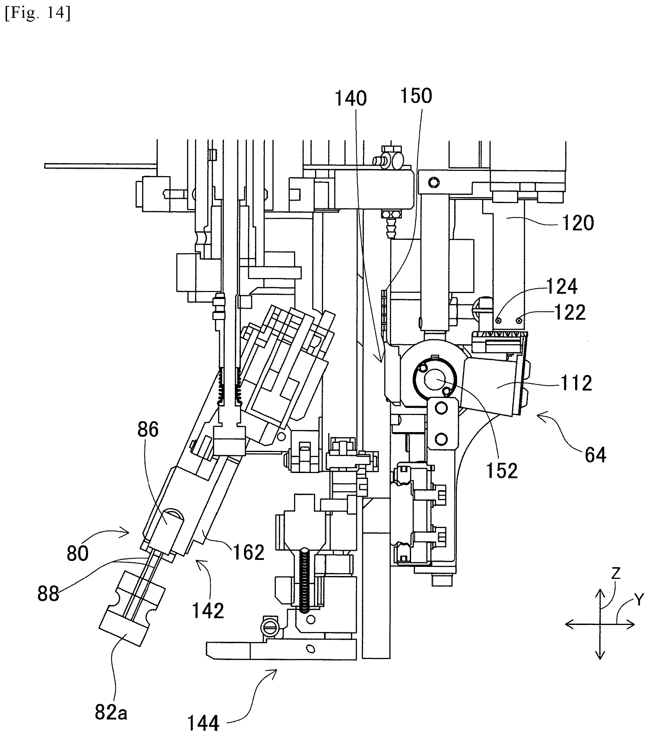

Figs. 13 and 14 illustrate a state in which radial lead component 80 in the middle of being conveyed is conveyed to a takeout position by executing a component discarding command. Hereinafter, radial lead component 80 in which part 82a of carrier tape 82 is attached to the pair of leads 88 is referred to as radial lead component 80 having a bad lead cut. As illustrated in Fig. 13, radial lead component 80 having a bad lead cut is delivered from first chuck 140 to second chuck 142, similarly to radial lead component 80 having no bad lead cut. Then, radial lead component 80 having a bad lead cut gripped by second chuck 142 is moved down toward the delivery position of third chuck 144 as described above. Then, radial lead component 80 having a bad lead cut gripped by second chuck 142 stops before extending in the vertical direction, and flange 188 is rotated by 180° by electromagnetic motor 192. Accordingly, as illustrated in Fig. 14, radial lead component 80 having a bad lead cut gripped by second chuck 142 is conveyed to a position where radial lead component 80 is easily taken out by the operator.

In the present embodiment, as described above with reference to Figs. 11 and 12, it is determined whether radial lead component 80 has a bad lead cut before radial lead component 80 is delivered from first chuck 140 to second chuck 142. When it is determined that radial lead component 80 has a bad lead cut, control device 28 immediately stops the operation of component mounter 10. That is, as illustrated in Fig. 12, radial lead component 80 having a bad lead cut is stopped in the middle of being conveyed by first chuck 140, and the subsequent conveyance to a position where the operator can easily take out radial lead component 80 is performed by control device 28 executing a component discarding command. However, the present invention is not limited thereto, and control device 28 may stop the operation of component mounter 10 after first chuck 140 delivers radial lead component 80 having a bad lead cut to second chuck 142 when it is determined that radial lead component 80 has a bad lead cut. In this case, an operation in which second chuck 142 receives radial lead component 80 having a bad lead cut and then conveys radial lead component 80 to a position where the operator can easily take out radial lead component 80 is performed by control device 28 executing a component discarding command. Further, in the present embodiment, when it is determined that radial lead component 80 has a bad lead cut, the operation of entire component mounter 10 is stopped, but the operation is not limited thereto, and the operation of a part of component mounter 10, for example, component supply device 24 and component mounting device 26, may be stopped.

In the present embodiment, when a component discarding command is executed, second chuck 142 receives and grips radial lead component 80 having a bad lead cut from first chuck 140, and conveys gripped radial lead component 80 having a bad lead cut to a position where the operator can easily take out radial lead component 80. At this time, as described above, the 180° rotation operation of flange 188 by electromagnetic motor 192 is performed after radial lead component 80 having a bad lead cut is moved down toward the delivery position of third chuck 144 and stopped before extending in the vertical direction. However, the present invention is not limited thereto, and the 180° rotation operation of flange 188 by electromagnetic motor 192 may be performed immediately from a state in which second chuck 142 receives and grips radial lead component 80 having a bad lead cut from first chuck 140 (see Fig. 13). In this case, the operation of moving radial lead component 80 having a bad lead cut down toward the delivery position of third chuck 144 is performed after the 180° rotation operation of flange 188. Alternatively, the rotation operation of flange 188 and the moving-down operation of radial lead component 80 having a bad lead cut may be performed in parallel.

Further, in the present embodiment, when it is determined that radial lead component 80 has a bad lead cut, a component discarding command is executed at the same time as component mounter 10 is stopped, the present invention is not limited thereto, and it is also possible to only stop component mounter 10 and not execute the component discarding command. In this case, whether to execute the component discarding command need only be left to the operator's selection.

As described above, component mounter 10 of the present embodiment includes cutting device 64 that cuts leads 88 of taped component 78 in which radial lead component 80 is taped on carrier tape 82 to separate radial lead component 80 from carrier tape 82, and bad lead cut detection sensor 124 that detects that cutting device 64 has failed to separate radial lead component 80 from carrier tape 82.

As described above, in component mounter 10 of the present embodiment, since bad lead cut detection sensor 124 detects that cutting device 64 has failed to separate radial lead component 80 from carrier tape 82, failure of cutting device 64 to separate radial lead component 80 from carrier tape 82 can be detected before radial lead component 80 is inserted into circuit base material 12. In the present embodiment, component mounter 10 is an example of a "board work machine". Radial lead component 80 is an example of a "lead component". Taped component 78 is an example of a "taped lead component". Bad lead cut detection sensor 124 is an example of a "detection device".

Further, bad lead cut detection sensor 124 detects that cutting device 64 has failed to separate radial lead component from carrier tape 82 by detecting that carrier tape 82 remains uncut on radial lead component 80 after the cutting operation by cutting device 64.

Further bad lead cut detection sensor 124 detects that carrier tape 82 remains uncut on radial lead component 80 while radial lead component 80 after the cutting operation by cutting device 64 is conveyed to a predetermined conveyance position.

Component mounter 10 further includes control device 28 that causes the conveyance of radial lead component 80 to stop when bad lead cut detection sensor 124 detects that cutting device 64 has failed to separate radial lead component from carrier tape 82. This makes it possible to prevent the device from being damaged due to radial lead component 80 having a bad lead cut.

Further, control device 28 performs control such that radial lead component 80 is conveyed to a predetermined takeout position, after stopping the conveyance of radial lead component 80. Accordingly, the operator can easily take out radial lead component 80 having a bad lead cut.

Component mounter 10 further includes component detection sensor 122 that detects whether taped component 78 is conveyed to a position where cutting device 64 performs a cutting operation. Bad lead cut detection sensor 124 detects that cutting device 64 has failed to separate radial lead component 80 from carrier tape 82 when component detection sensor 122 detects that taped component 78 has been conveyed to the position where cutting device 64 performs the cutting operation.

Accordingly, it is possible to prevent bad lead cut detection sensor 124 from erroneously detecting that cutting device 64 has failed to separate the radial lead component that has not been conveyed from carrier tape 82. In addition, component detection sensor 122 is an example of a "component detection device".

The present disclosure is not limited to the above embodiment, and various modifications can be made within the scope without departing from the concept of the present disclosure.
(1) In the above embodiment, the radial lead component includes a pair of leads, but the number of leads may be one or three or more. The method of the present disclosure can also be applied to a taped axial lead component that is taped with an axial lead component on a carrier tape.
(2) In the above embodiment, transmission type optical sensors are used as component detection sensor 122 and bad lead cut detection sensor 124, but the present invention is not limited thereto, and other types of optical sensors such as a reflection type may be used. Other types of sensors such as an infrared sensor, an ultrasonic sensor, and a contact sensor may be used.

### Reference Signs List

10: component mounter, 28: control device, 64: cutting device, 78: taped component, 80: radial lead component, 82: carrier tape, 122: component detection sensor, 124: bad lead cut detection sensor

## Claims

1. A board work machine comprising:
a cutting device configured to cut a lead of a taped lead component that is taped with a lead component on a carrier tape to separate the lead component from the carrier tape; and
a detection device configured to detect that the cutting device has failed to separate the lead component from the carrier tape.

2. The board work machine according to Claim 1, wherein
the detection device detects that the cutting device has failed to separate the lead component from the carrier tape by detecting that the carrier tape remains uncut on the lead component after a cutting operation by the cutting device.

3. The board work machine according to Claim 2, wherein
the detection device detects that the carrier tape remains uncut on the lead component while the lead component after the cutting operation by the cutting device is conveyed to a predetermined conveyance position.

4. The board work machine according to any one of Claims 1 to 3, further comprising:
a control device configured to cause conveyance of the lead component to stop when the detection device detects that the cutting device has failed to separate the lead component from the carrier tape.

5. The board work machine according to Claim 4, wherein
the control device causes the lead component to be conveyed to a predetermined takeout position after stopping the conveyance of the lead component.

6. The board work machine according to any one of Claims 1 to 5, further comprising:
a component detection device configured to detect whether the taped lead component has been conveyed to a position where the cutting device performs a cutting operation, wherein
the detection device detects that the cutting device has failed to separate the lead component from the carrier tape when the component detection device detects that the taped lead component has been conveyed to the position where the cutting device performs a cutting operation.

7. A board manufacturing method comprising:
detection processing of detecting that a cutting device that cuts a lead of a taped lead component that is taped with a lead component on a carrier tape to separate the lead component from the carrier tape has failed to separate the lead component from the carrier tape.
